# EUROPEAN PATENT APPLICATION

(11) **EP 4 496 443 A1**
(43) Date of publication of application: **22.01.2025**
(21) Application number: 24187765.3
(22) Date of filing: 10.07.2024
(51) Int. Cl.: H05K 7/20

(54) **HEAT DISSIPATION DEVICE FOR ELECTRONIC COMPONENT, ELECTRICAL CONVERTER AND VEHICLE**

(30) Priority: 17.07.2023 CN 202310875663
(71) Applicant: Valeo eAutomotive Germany GmbH, 91056 Erlangen (DE)
(72) Inventor: HU, Dong, 91056 ERLANGEN (DE); ZHANG, Cansheng, 91056 ERLANGEN (DE)
(74) Representative: Valeo Powertrain Systems

(57) **Abstract**

The present disclosure relates to a heat dissipation device for an electronic component. The heat dissipation device includes: a heat dissipation component arranged at a first side of the electronic component; and a pressing component arranged at a second side of the electronic component opposite the first side, wherein the pressing component includes a pressure plate and a pressure block, and the pressure block passes through the pressure plate and contacts the electronic component, and the pressure plate is connected to a fixed structure to apply a force towards the heat dissipation component to the electronic component via the pressure block. The present disclosure also relates to an electrical converter including the heat dissipation device, and a vehicle including the electrical converter.

## Description

### Technical Field

The present disclosure relates to a heat dissipation device for an electronic component, in particular to a heat dissipation device that is fitted in a vehicle and is used for an electronic component of an electrical converter, ensuring good thermal contact between the heat dissipation device and the electronic component.

### Background Art

The operating temperature of an electronic component directly affects its own reliability. For example, in a power conversion circuit of an AC-DC converter or DC-AC converter or DC-DC converter, a power semiconductor device serves an important function, and the operating state thereof directly affects the reliability of operation of the entire apparatus. During use, the power semiconductor device will consume a portion of energy and convert this to heat, with the result that the power semiconductor device heats up, and the junction temperature rises. When the junction temperature exceeds a safety threshold, the current will increase sharply, and this may even cause a transistor to burn out. Thus, heat needs to be rapidly released to the surroundings by means of a heat dissipation device, to lower the operating temperature of the electronic component. To ensure stable operation of the heat dissipation device, good thermal contact between the heat dissipation device and the electronic component needs to be maintained.

### Summary of the Invention

An object of the present disclosure is to propose a heat dissipation device for an electronic component, wherein the heat dissipation device has a simple manufacturing process and saves on costs, can protect the electronic component against damage, has a simple disassembly process, and can enhance electrical insulation.

At least one embodiment of the present disclosure provides a heat dissipation device for an electronic component. The heat dissipation device comprises: a heat dissipation component arranged at a first side of the electronic component; and a pressing component arranged at a second side of the electronic component opposite the first side; wherein the pressing component comprises a pressure plate and a pressure block, the pressure block passes through the pressure plate and contacts the electronic component, and the pressure plate is connected to a fixed structure to apply a force towards the heat dissipation component to the electronic component via the pressure block.

For example, in the heat dissipation device provided by at least one embodiment of the present disclosure, the pressure plate is provided with at least one through hole, the pressure block comprises a first member, and a free end of the first member is able to pass through the through hole and press against a first side of the pressure plate.

For example, in the heat dissipation device provided by at least one embodiment of the present disclosure, the pressure block further comprises a second member, the second member is configured to have a first end that presses against a second side of the pressure plate opposite the first side, and a second end that is able to press against the electronic component.

For example, in the heat dissipation device provided by at least one embodiment of the present disclosure, the free end of the first member has a head part, and the head part is made of a deformable material and has a diameter larger than a diameter of the through hole, such that the head part is able to converge and deform towards the centre of the head part when passing through the through hole, and open out away from the centre after passing through the through hole to press against the first side of the pressure plate.

For example, in the heat dissipation device provided by at least one embodiment of the present disclosure, the head part is formed by multiple segments, and the multiple segments are configured to be symmetrical or asymmetrical.

For example, in the heat dissipation device provided by at least one embodiment of the present disclosure, the pressure plate is in a shape of a flat plate, and an edge of the pressure plate is provided with a reinforcing rib.

For example, in the heat dissipation device provided by at least one embodiment of the present disclosure, the pressure plate comprises at least one arc-shaped sheet-like structure, each sheet-like structure comprises a top part and two branch parts extending from the top part.

For example, in the heat dissipation device provided by at least one embodiment of the present disclosure, the pressure plate comprises a hollowed-out part arranged around the through hole or the pressure block, the hollowed-out part is arranged symmetrically along the through hole or the pressure block.

For example, in the heat dissipation device provided by at least one embodiment of the present disclosure, the pressing component comprises multiple pressure blocks, the multiple pressure blocks are distributed in a first direction and mounted on the pressure plate, the hollowed-out part is arranged symmetrically with a central axis of the pressure plate in a first direction as an axis of symmetry, and is arranged symmetrically with a central axis of the pressure plate perpendicular to the first direction as an axis of symmetry.

For example, in the heat dissipation device provided by at least one embodiment of the present disclosure, material of the pressure block comprises plastic or rubber.

For example, in the heat dissipation device provided by at least one embodiment of the present disclosure, the electronic component is accommodated in a housing and electrically connected to a printed circuit board, and wherein the fixed structure is a portion of the heat dissipation component or a portion of the housing, and the pressing component is firmly connected to the fixed structure.

For example, the heat dissipation device provided by at least one embodiment of the present disclosure further comprises an electrical insulation sheet, the electrical insulation sheet is arranged between the heat dissipation component and the electronic component.

For example, in the heat dissipation device provided by at least one embodiment of the present disclosure, the electronic component comprises a MOSFET.

Another embodiment of the present disclosure further provides an electrical converter, the electrical converter comprises an AC-DC converter or a DC-AC converter or a DC-DC converter, and the electrical converter comprises the heat dissipation device provided by at least one embodiment of the present disclosure.

A further embodiment of the present disclosure further provides a vehicle, comprising the electrical converter provided in at least one embodiment of the present disclosure.

### Brief Description of the Drawings

To explain the technical solutions of embodiments of the present disclosure more clearly, the drawings which need to be used in describing the embodiments are described in simple terms below. Obviously, the drawings in the description below are merely some embodiments of the present disclosure, and those skilled in the art could obtain other drawings based on these drawings without expending inventive effort. The drawings below have not been drawn by meticulously reducing or enlarging actual dimensions in equal proportion, but focus on showing the substance of the present disclosure.
Fig. 1 is a structural schematic drawing of a heat dissipation device for an electronic component provided according to at least one embodiment of the present disclosure;
Fig. 2 is a structural schematic drawing of a pressing component provided according to at least one embodiment of the present disclosure;
Fig. 3 is a structural schematic drawing of a pressure block provided according to at least one embodiment of the present disclosure;
Fig. 4 is a structural schematic drawing of another pressure block provided according to at least one embodiment of the present disclosure;
Fig. 5 is a structural schematic drawing of another pressure block provided according to at least one embodiment of the present disclosure;
Fig. 6 is a structural schematic drawing of a pressure plate provided according to at least one embodiment of the present disclosure;
Fig. 7 is a structural schematic drawing of another pressure plate provided according to at least one embodiment of the present disclosure;
Fig. 8 is a structural schematic drawing of another pressure plate provided according to at least one embodiment of the present disclosure;
Fig. 9 is a structural schematic drawing of another pressure plate provided according to at least one embodiment of the present disclosure;
Fig. 10 is a structural schematic drawing of another heat dissipation device for an electronic component provided according to at least one embodiment of the present disclosure.

In all the drawings, identical or similar components are denoted by identical reference signs.

### Detailed Description of Embodiments

To clarify the objective, technical solutions and advantages of embodiments of the present disclosure, the technical solutions of the embodiments of the present disclosure are described clearly and completely below in conjunction with the drawings of the embodiments of the present disclosure.

Unless defined otherwise, the technical or scientific terms used herein shall have the common meanings as understood by those of ordinary skill in the art to which the present disclosure belongs. Words such as "an", "a" or "the" used in the description and the claims of the patent application disclosed herein do not indicate a quantity limit, but mean that there is at least one. "Comprise", "include" or any other similar term means that the element or object appearing before the term covers the elements or objects and equivalents thereof listed after the term but does not exclude other elements or objects. Words such as "connected" or "linked" are not restricted to a physical or mechanical connection, and may include an electrical connection, whether direct or indirect.

In order to facilitate description, the drawings of the present disclosure accordingly simplify or omit components commonly used in the art, such as external connection lines and other components that are irrelevant to the description of the present disclosure. These omitted or simplified components do not affect the understanding of the content of the present disclosure by a person skilled in the art.

The use of a pressure plate and bolts to maintain contact between the heat dissipation device and the electronic component is known in the prior art. Specifically, the pressure plate is directly placed above the electronic component, and connected to a heat dissipation component at a suitable position, such that the electronic component is pressed tightly against the heat dissipation component by means of the pressure plate. The most obvious drawback of this solution is that the rigid action force of the pressure plate is applied to the electronic component directly, and this might cause damage to the electronic component, which has a rather fragile structure.

The use of an elastic piece to maintain contact between the heat dissipation device and the electronic component is also known in the prior art. Specifically, the elastic piece is placed above the electronic component, and connected to a heat dissipation component at a suitable position, such that the electronic component is pressed tightly against the heat dissipation component. This solution requires a hard elastic piece, which is difficult to process, and if the elastic piece is directly pressed on the electronic component, problems of damage to the electronic component and voltage emerge.

At least one embodiment of the present disclosure provides a heat dissipation device for an electronic component, the heat dissipation device comprises: a heat dissipation component arranged at a first side of the electronic component; and a pressing component arranged at a second side of the electronic component opposite the first side; wherein the pressing component comprises a pressure plate and a pressure block, the pressure block passes through the pressure plate and contacts the electronic component, and the pressure plate is connected to a fixed structure to apply a force towards the heat dissipation component to the electronic component via the pressure block.

The heat dissipation device provided by the present disclosure at least overcomes the above defect in the prior art. The heat dissipation device has a simple manufacturing process and saves on costs, can protect the electronic component against damage, has a simple disassembly process, and can enhance electrical insulation.

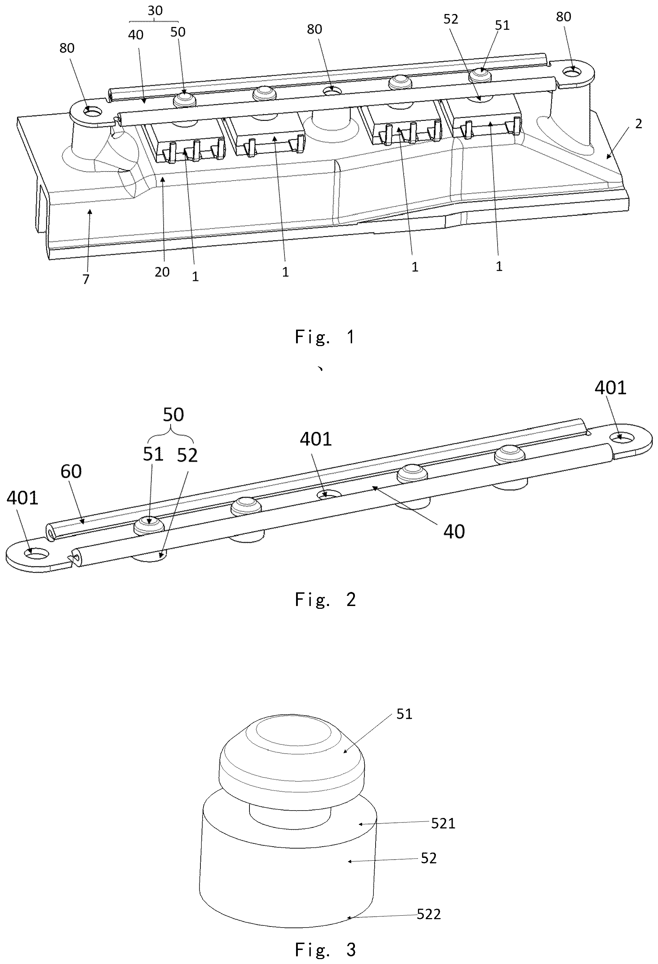

Fig. 1 shows a heat dissipation device 2 for an electronic component 1 provided according to at least one embodiment of the present disclosure. The electronic component 1, for example, is a circuit component part of an electronic apparatus. In some embodiments, the electronic apparatus is for example an onboard AC-DC converter or DC-AC converter or DC-DC converter. These electronic apparatuses often generate large amounts of heat with high currents during operation. However, it should be understood that the heat dissipation device 2 according to the present disclosure may also be used in other industrial fields comprising consumer electronics, electric household appliances, engineering machinery and electrical apparatuses.

As shown in Fig. 1, the electronic apparatus comprises a housing 7 and a printed circuit board (not shown) accommodated in the housing 7. For convenience of description, only part of the electronic apparatus is shown in Fig. 1. At least one electronic component 1, for example, is electrically connected to the printed circuit board by means of pins. In Fig. 1, the number of electronic components 1 is 4 for example. It should be explained that the number of electronic components 1 being 4 is merely an example, and the present disclosure does not impose a restriction on the number of electronic components 1. The electronic component 1, for example, is a power semiconductor device, such as a MOSFET (metal-oxide-semiconductor field-effect transistor), which will consume a portion of energy and convert this to a large amount of heat during use, with the result that the electronic component 1 heats up, and the junction temperature rises. It should be explained that the MOSFET is merely an example, and the present disclosure does not impose a restriction on the type of the electronic component 1. For this reason, the heat dissipation device 2 is provided for the at least one electronic component 1, as described in detail below.

The heat dissipation device 2 comprises a heat dissipation component 20, also called a heat sink, that is arranged at a lower side of the electronic component 1. The heat dissipation component 20 can undergo heat exchange with the electronic component 1 and absorb the heat generated by the electronic component 1 during operation, to lower the temperature of the electronic component 1. In some embodiments, the heat dissipation component 20 is formed as a portion of the housing 7, as shown in Fig. 1. In other embodiments, the heat dissipation component 20 and the housing 7 are formed as separate components.

As shown in Fig. 1, the heat dissipation device 2 comprises a pressing component 30. The pressing component 30 is arranged on an upper side of the electronic component 1, i.e., at the side opposite the heat dissipation component 20.

As shown in Fig. 1, the pressing component 30 comprises a pressure plate 40 and a pressure block 50, and the number of pressure blocks 50 is 4, to correspond to the number of electronic components 1. It should be explained that the present disclosure does not impose a restriction on the number of pressure blocks 50, which may be chosen at will according to a heat sink. The pressure blocks 50 are mounted on the pressure plate 40 in a first direction. The first direction is an arrangement direction of the electronic components 1. The pressure block 50 passes through the pressure plate 40 and contacts the electronic components 1, and the pressure plate 40 is connected to a fixed structure to apply a force towards the heat dissipation component 20 to the electronic component 1 via the pressure block 50.

For example, in some embodiments of the present disclosure, material of the pressure block 50 comprises plastic or rubber.

Since the plastic or rubber material is elastic, a rigid action force being applied to the electronic component, causing damage thereto, when the electronic component is pressed on is prevented. Moreover, the plastic or rubber material may enhance electrical insulation.

The plastic or rubber material described above are merely some examples. The pressure block 50 may also be made of other materials with good insulation and relatively low hardness, as long as application of a potentially damaging rigid action force to the electronic component 1 can be prevented, and the present disclosure does not impose a restriction on this.

This configuration according to the present disclosure can avoid the direct application of a rigid action force to the electronic component 1, preventing the electronic component 1 from experiencing local concentrated strain and thereby being damaged. In addition, since the pressure plate 40 is connected to the fixed structure, as time passes, the pressure block 50 can still apply a sufficient elastic action force to the electronic component 1, thereby forming stable and reliable thermal contact between the electronic component 1 and the heat dissipation component 20.

Moreover, the manufacturing process for the heat dissipation device is simple, and using a pressure block of plastic or rubber material can save on costs.

Fig. 2 shows a structural schematic drawing of the pressing component 30 shown in Fig. 1.

As shown in Fig. 2, the pressure plate 40 is provided with at least one through hole 401. The pressure block 50 comprises a first member 51, and a free end of the first member 51 is able to pass through the through hole 401 and press against the first side of the pressure plate 40. The pressure block 50 further comprises a second member 52. The second member 52 is provided with a first end 521, which presses against a second side of the pressure plate 40 opposite the first side, and a second end 522 which can press against the electronic component 1. For the specific structure of the pressure block 50, see Fig. 3.

As shown in Fig. 3, the free end of the first member 51 has a head part, and the head part is made of a deformable material and has a diameter larger than a diameter of the through hole 401, such that the head part is able to converge and deform towards the centre of the head part when passing through the through hole 401, and open out away from the centre after passing through the through hole 401 to press against the first side of the pressure plate 40.

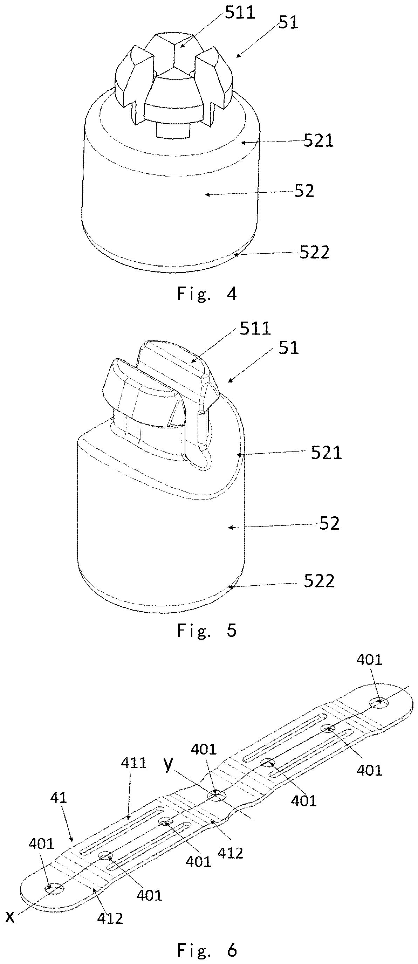

In order to better fit the first member 51 into the pressure plate 40, for example, in some embodiments of the present disclosure, the head part is formed by multiple segments 511, and the multiple segments 511 are configured to be symmetrical or asymmetrical; for the specific structures, see Fig. 4 and Fig. 5.

As shown in Fig. 4, the head part of the free end of the first member 51 has 4 segments 511 that are symmetrical; as best shown in Fig. 5, the head part of the free end of the first member 51 has 2 segments 511 that are symmetrical. In the process of fitting the first member 51 into the pressure plate 40, the segmented structure converges towards the centre, such that the first member 51 can contract and pass through the through hole 401, enabling the first member 51 to be more conveniently fitted into the pressure plate 40.

It should be explained that the structures of the pressure block 50 shown in Fig. 3 - Fig. 5 are merely some examples, and the present disclosure does not impose a restriction on the specific structure of the pressure block 50.

Returning to Fig. 2, as shown in Fig. 2, the pressure plate 40 is in a shape of a flat plate, and an edge of the pressure plate 40 is provided with a reinforcing rib. The reinforcing rib 60 can increase the strength of the pressure plate 40. Two through holes 401 that are closest to either end of the pressure plate 40 and a through hole 401 that is at the exact middle thereof are used for mounting fastening members (such as bolts), and the through holes 401 at remaining positions of the pressure plate 40 are used for mounting the pressure blocks 50.

Besides the structure of the pressure plate 40 shown in Fig. 2, the present disclosure further provides other examples of the structure of the pressure plate 40; for example, see Fig. 6 - Fig. 9.

As shown in Fig. 6, the pressure plate 40 comprises at least one arc-shaped sheet-like structure 41. Each sheet-like structure comprises a top part 411 and two branch parts 412 extending from the top part. By means of adding an undulating design to the pressure plate 40, the stress distribution of various positions of the pressure plate 40 can be made uniform. Two through holes 401 that are closest to either end of the pressure plate 40 and a through hole 401 that is at the exact middle thereof are used for mounting fastening members (such as bolts), and the through holes 401 at remaining positions of the pressure plate 40 are used for mounting the pressure blocks 50. The pressure plate 40 comprises hollowed-out parts arranged around the through holes 401 or the pressure blocks 50, the hollowed-out parts are arranged symmetrically along the through holes 401 or the pressure blocks 50. The hollowed-out parts are arranged symmetrically with a central axis of the pressure plate 40 in a first direction as an axis of symmetry (marked as an x-axis), and are arranged symmetrically with a central axis of the pressure plate 40 perpendicular to the first direction as an axis of symmetry (marked as a y-axis).

The hollowed-out parts arranged on the pressure plate 40 can somewhat deform when pressure on the electronic component 1 is especially large, thereby absorbing excess stress, preventing damage to the electronic component 1.

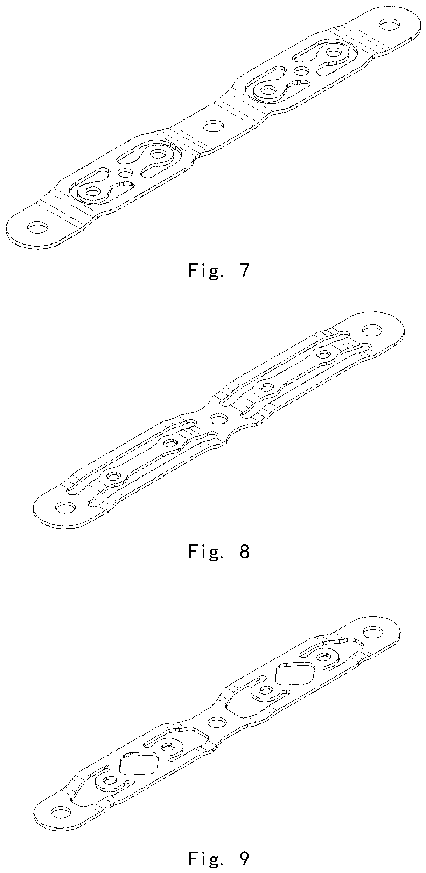

The hollowed-out parts on the pressure plate 40 may be designed as various shapes, for example, see Fig. 7 - Fig. 9. In Fig.7 - Fig. 9, multiple hollowed-out parts as a whole on the pressure plate 40 assume a symmetrical structure, are arranged symmetrically with a central axis of the pressure plate 40 in a first direction as an axis of symmetry, and are arranged symmetrically with a central axis of the pressure plate 40 perpendicular to the first direction as an axis of symmetry, and the present disclosure does not impose a restriction on the shape of the hollowed-out parts on the pressure plate 40.

It should be explained that the structures of the pressure plate 40 shown in Fig. 6 - Fig. 9 are merely some examples, and the present disclosure does not impose a restriction on the structure of the pressure plate 40. For example, the reinforcing rib structure shown in Fig. 6 may be combined with the hollowed-out parts shown in Fig. 7 - Fig. 9 to form a new pressure plate 40.

For example, in some embodiments of the present disclosure, the pressure plate 40 is made of a metal or other material with reliable performance, for example a metal such as 301 stainless steel.

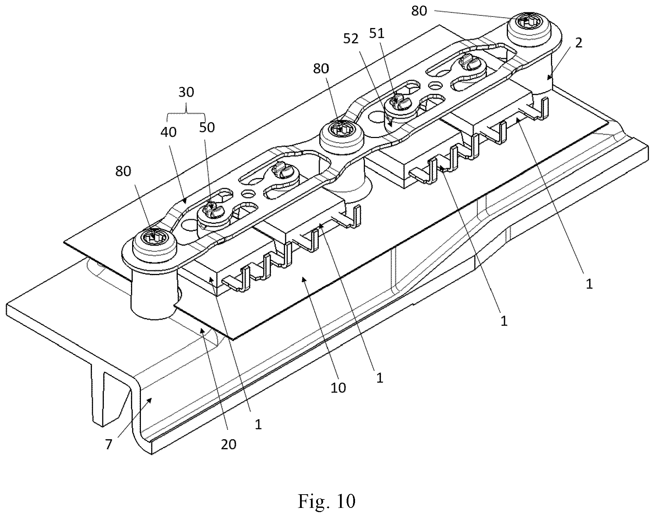

Fig. 10 shows another heat dissipation device for an electronic component provided by at least one embodiment of the present disclosure. The difference between Fig. 10 and Fig. 1 is that a different pressing component 30 is used. The pressing component 30 shown in Fig. 2 is used in Fig. 1, whereas a pressing component 30 which combines the pressure block shown in Fig. 5 and the pressure plate shown in Fig. 7 is used in Fig. 10.

For example, in some embodiments of the present disclosure, the heat dissipation device 2 may comprise an electrical insulation sheet 10 that is arranged between the heat dissipation component 20 and the electronic component 1, and that is used for separating the heat dissipation component 20 and the electronic component 1. The electrical insulation sheet 10 is made of an insulation material and, preferably, may be an electrical insulation material having good heat conductivity, for example, a heat-conducting silicone pad and a heat-conducting filler material, to promote heat exchange between the heat dissipation component 20 and the electronic component 1.

For other components of the heat dissipation device shown in Fig. 10, see the relevant descriptions of Fig. 1 which will not be repeated here.

It should be explained that other different combinations of pressure blocks and pressure plates may further be used to form different pressing components for the heat dissipation device, and the present disclosure does not impose a restriction on this.

In some embodiments, the fixed structure may be a portion of the printed circuit board.

In some embodiments, the fixed structure may be a portion of the housing 7 of the electronic apparatus, that is, the pressure plate 40 is connected to a portion of the housing 7.

In some embodiments, the fixed structure may be a portion of the heat dissipation component 20, and the heat dissipation component 20 may be connected to the housing 7 of the electronic apparatus, that is, the pressure plate 40 is connected to a portion of the heat dissipation component 20, and the heat dissipation component 20 is connected to the housing 7.

The fixed structure is a portion of the housing 7 of the electronic apparatus or the fixed structure is a portion of the heat dissipation component 20, and the heat dissipation component 20 may be connected to the housing 7 of the electronic apparatus. In these two configurations, the pressure plate 40 is directly or indirectly fixed to the housing 7 of the electronic apparatus. This is especially advantageous in the case where the electronic apparatus is an onboard electronic apparatus, such as an onboard AC-DC converter or DC-AC converter or DC-DC converter. The running of a vehicle is generally accompanied by vibration of the onboard electronic apparatus; such vibration might cause loosening of the thermal contact between the electronic component 1 and the heat dissipation component 20, thereby weakening the heat dissipation effect. Having the pressure plate 40 directly or indirectly fixed to the housing 7 of the electronic apparatus enables the positioning of the pressure plate to be more reliable, thereby resisting the adverse effect of vibration on thermal contact.

In some embodiments, the pressure plate 40 is firmly connected to the fixed structure. It is possible to use an almost permanent connection (e.g., welding, adhesive, riveting, etc.), or a removable connection with one or more fasteners (e.g., a screw, bolt, snap-fit connection, etc.). As shown in Fig. 1 and Fig. 10, the pressure plate 40 is fixed to the fixed structure by means of bolts 80, two ends and the middle of the pressure plate 40 are fixed with 3 bolts 80. The middle of the pressure plate 40 being fixed with a bolt 80 is to increase the pressure to which two pressure blocks 50 at the middle are subjected. If there is no middle bolt 80 for fixing, then the pressure to which the two pressure blocks 50 at the middle of the pressure plate are subjected is less. An action force applied by the pressure blocks 50 to the electronic component 1 may be adjusted by means of adjusting the bolts 80.

At least one embodiment of the present disclosure further provides an electrical converter. The electrical converter comprises an AC-DC converter or a DC-AC converter or a DC-DC converter, and the electrical converter comprises the heat dissipation device 2 provided by at least one embodiment of the present disclosure.

For example, in the electrical converter provided by at least one embodiment of the present disclosure, the electrical converter is provided with a housing, wherein the fixed structure is a portion of the housing, or the fixed structure is a portion of the heat dissipation component and the heat dissipation component is connected to the housing.

At least one embodiment of the present disclosure further provides a vehicle, comprising the electrical converter provided in at least one embodiment of the present disclosure. The vehicle may be an electrified vehicle, such as a battery electric vehicle (BEV), a hybrid electric vehicle (HEV), a plug-in hybrid electric vehicle (PHEV), a range extended EV and a fuel cell electric vehicle (FCEV). The vehicle may also be a hydrogen-powered vehicle.

Certain features, structures or characteristics in one or more embodiments of the present disclosure may be combined appropriately.

The above is a description of the present disclosure and should not be construed as a limitation thereon. Although several exemplary embodiments of the present disclosure have been described, those of ordinary skill in the art will readily understand that many modifications may be made to the exemplary embodiments without departing from the novel teaching and advantages of the present disclosure. Therefore, all such modifications are intended to be included in the scope of the present disclosure as defined by the claims. It should be understood that the above is a description of the present disclosure, that the present disclosure should not be deemed to be limited to the specific embodiments disclosed herein, and that modifications to the embodiments disclosed herein and other embodiments are intended to be included within the scope of the present disclosure.

## Claims

1. A heat dissipation device (2) for an electronic component (1), **characterized in that** the heat dissipation device (2) comprises:
a heat dissipation component (20) arranged at a first side of the electronic component (1); and
a pressing component (30) arranged at a second side of the electronic component (1) opposite the first side,
wherein the pressing component (30) comprises a pressure plate (40) and a pressure block (50), the pressure block (50) passes through the pressure plate (40) and contacts the electronic component (1), and the pressure plate (40) is connected to a fixed structure to apply a force towards the heat dissipation component (20) to the electronic component (1) via the pressure block (50).

2. The heat dissipation device (2) according to claim 1, **characterized in that** the pressure plate (40) is provided with at least one through hole (401), the pressure block (50) comprises a first member (51), and a free end of the first member (51) is able to pass through the through hole (401) and press against a first side of the pressure plate (40).

3. The heat dissipation device (2) according to claim 2, **characterized in that** the pressure block (50) further comprises a second member (52), the second member (52) is configured to have a first end (521) that presses against a second side of the pressure plate (40) opposite the first side, and a second end (522) that is able to press against the electronic component (1).

4. The heat dissipation device (2) according to claim 2, **characterized in that** the free end of the first member (51) has a head part, and the head part is made of a deformable material and has a diameter larger than a diameter of the through hole (401), such that the head part is able to converge and deform towards the centre of the head part when passing through the through hole (401), and open out away from the centre after passing through the through hole (401) to press against the first side of the pressure plate (40).

5. The heat dissipation device (2) according to claim 4, **characterized in that** the head part is formed by multiple segments (511), and the multiple segments (511) are configured to be symmetrical or asymmetrical.

6. The heat dissipation device (2) according to claim 1, **characterized in that** the pressure plate (40) is in a shape of a flat plate, and an edge of the pressure plate (40) is provided with a reinforcing rib.

7. The heat dissipation device (2) according to claim 1, **characterized in that** the pressure plate (40) comprises at least one arc-shaped sheet-like structure (41), each sheet-like structure (41) comprises a top part (411) and two branch parts (412) extending from the top part.

8. The heat dissipation device (2) according to claim 7, **characterized in that** the pressure plate (40) comprises a hollowed-out part arranged around the through hole (401) or the pressure block (50), the hollowed-out part is arranged symmetrically along the through hole (401) or the pressure block (50).

9. The heat dissipation device (2) according to claim 8, **characterized in that** the pressing component (30) comprises multiple pressure blocks (50), the multiple pressure blocks (50) are distributed in a first direction and mounted on the pressure plate (40), the hollowed-out part is arranged symmetrically with a central axis of the pressure plate (40) in a first direction as an axis of symmetry, and is arranged symmetrically with a central axis of the pressure plate (40) perpendicular to the first direction as an axis of symmetry.

10. The heat dissipation device (2) according to any one of claims 1 to 9, **characterized in that** material of the pressure block (50) comprises plastic or rubber.

11. The heat dissipation device (2) according to any one of claims 1 to 9, **characterized in that** the electronic component (1) is accommodated in a housing (7) and is electrically connected to a printed circuit board, wherein the fixed structure is a portion of the heat dissipation component (20) or a portion of the housing (7) or a portion of the printed circuit board, and the pressing component (30) is firmly connected to the fixed structure.

12. The heat dissipation device (2) according to any one of claims 1 to 9, **characterized in that** the heat dissipation device (2) further comprises an electrical insulation sheet (10), and the electrical insulation sheet (10) is arranged between the heat dissipation component (20) and the electronic component (1).

13. The heat dissipation device (2) according to any one of claims 1 to 9, **characterized in that** the electronic component (1) comprises a MOSFET.

14. An electrical converter, **characterized in that** the electrical converter comprises an AC-DC converter or a DC-AC converter or a DC-DC converter, and the electrical converter comprises the heat dissipation device according to any one of claims 1 to 13.

15. A vehicle, **characterized in that** the vehicle comprises the electrical converter according to claim 14.
